# EUROPÄISCHE PATENTANMELDUNG

(11) **EP 1 221 741 A2**
(43) Veröffentlichungstag der Anmeldung: **10.07.2002**
(21) Anmeldenummer: 01129694.4
(22) Anmeldetag: 13.12.2001
(51) Int. Cl.: H01R 9/24

(54) **Verteiler für die Versorgung von Aktoren und/oder Sensoren**

(30) Priorität: 05.01.2001 DE 20100165 U
(71) Anmelder: Weidmüller Interface GmbH & Co., 32760 Detmold (DE)
(72) Erfinder: Reker, Stefan, 33659 Bielefeld (DE)
(74) Vertreter: Specht, Peter, Dipl.-Phys.

(57) **Zusammenfassung**

Ein Verteiler für die Versorgung der Aktoren und/oder Sensoren mit Anschlüssen für die Aktoren und/oder Sensoren sowie einer Elektronik für die Versorgung der Aktoren und/oder Sensoren und die Weiterleitung der Aktoren-Sensoren-Signale, zeichnet sich dadurch aus, daß die Anschlüsse (4a', ..) derart viel Pole aufweisen, daß eine Satellitenstruktur aus Verteilern (10a-d) gebildet werden kann, bei welcher an die Anschlüsse (4a',...) eines Verteilers (1) jeweils ein weiterer Satellitenverteiler (10), der seinerseits mehrere Anschlüsse aufweist, anschließbar ist.

## Beschreibung

Die Erfindung betrifft einen Verteiler für die Versorgung von Aktoren und/oder Sensoren mit Anschlüssen für die Aktoren und/oder Sensoren sowie einer Elektronik für die Versorgung der Aktoren und/oder Sensoren und die Weiterleitung der Aktoren-Sensoren-Signale.

Ein derartiger passiver Verteiler ist aus der G 29905025 bekannt. Dieser Verteiler hat sich an sich bewährt. Es besteht jedoch der Bedarf nach einer Weiterbildung derart, daß der Verteiler eine geringe Masse z.B. für bewegliche Achsen aufweist, wobei eine hohe Anschlußdichte von Sensoren und Aktoren auf engem Raum realisierbar sein soll.

Die Lösung dieses Problems ist die Aufgabe der Erfindung.

Die Erfindung löst diese Aufgabe durch den Gegenstand des Anspruches 1.

Danach weisen die Anschlüsse derart viel Pole bzw. mehr als zwei Schaltdrähte auf, so daß eine Satellitenstruktur aus Verteilern gebildet werden kann, bei welcher an die Anschlüsse eines Verteilers jeweils ein weiterer Satellitenverteiler, der seinerseits mehrere Anschlüsse aufweist, anschließbar ist.

Der besondere Vorteil dieser Anordnung ist darin zu sehen, daß durch die geringe Anzahl der Anschlüsse am vorzugsweise passiven Verteiler einerseits die Masse des Verteilers verringert wird, was z.B. bei einer Anordnung an beweglichen Achsen vorteilhaft ist. Darüber hinaus werden die E-/A-Punkte des Verteilers max. ausgenutzt und durch die Satellitenverteiler besonders kurze Kabelverbindungen zu den Sensoren und/oder Aktoren realisierbar. Die bevorzugte Belegung ist dabei wie folgt: "+, -, PE, vier Schaltdrähte, ein freier Anschluß".

Vorzugsweise weist jeder Verteiler mehrere, vorzugsweise vier Anschlüsse auf, welche jeweils mehrpolig, insbesondere achtpolig ausgebildet sind und denen jeweils eine Mehrzahl, insbesondere vier, der Satellitenverteiler nachschaltbar sind.

Vorzugsweise ist die Belegung der Anschlüsse des passiven Verteilers wie folgt: Plus, Minus, PE, mehrere, insbesondere vier, Schaltdrähte, vorzugsweise ein freier Anschluß.

Vorteilhafte Ausgestaltungen der Erfindung sind den Unteransprüchen zu entnehmen.

Nachfolgend wird ein Ausführungsbeispiel unter Bezug auf die Figur näher beschrieben. Es zeigt:

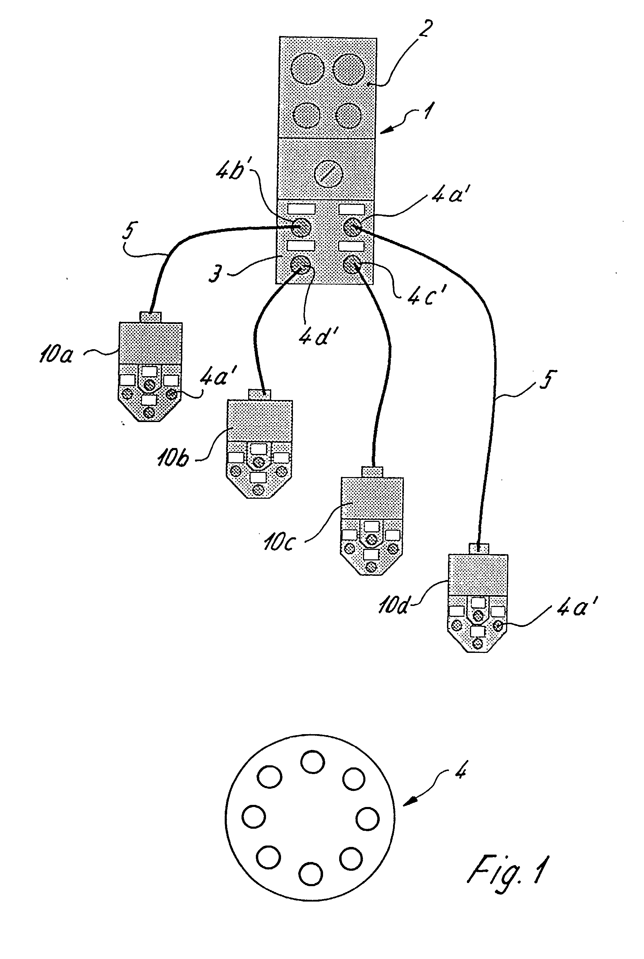

- Fig. 1: eine schematische Ansicht eines erfindungsgemäßen Verteilersystems; und
- Fig. 2: eine schematische Ansicht eines Verteilers nach dem Stand der Technik.

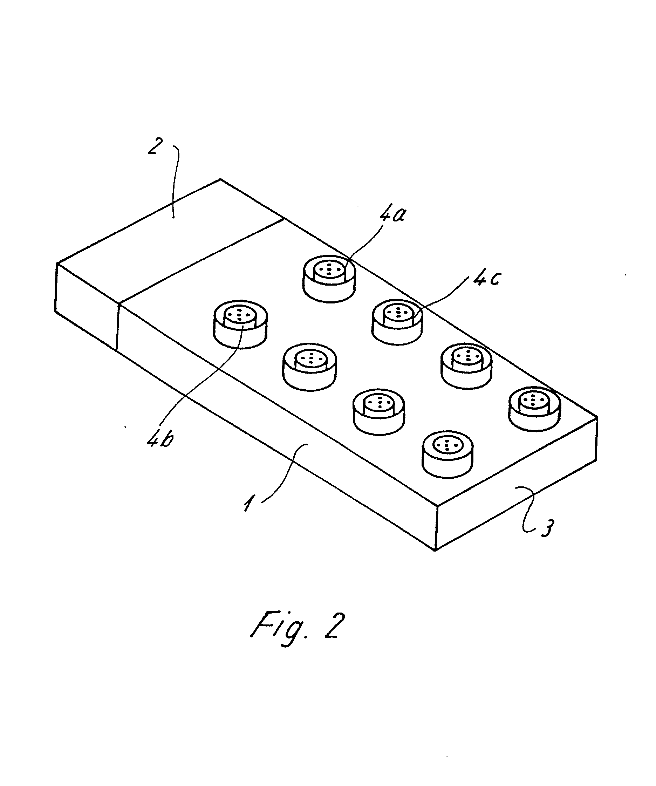

In Fig. 2 ist ein passiver Verteiler 1 dargestellt, an dessen mit einer Elektronik versehenes Gehäuseteil 2 Datenleitungen von und zu einer übergeordneten Steuerungseinrichtung (Master-Slave-Konfiguration) anschließbar sind.

Dieses Gehäuseteil 2 ist entweder einstückig mit einem Gehäuseteil 3 ausgebildet oder an dieses mit einer Elektronik (hier nicht detailliert dargestellt) ansteck- und von diesem abnehmbar. Das Gehäuseteil 3 ist hier mit acht Anschlüssen 4a, 4b, ... zum Anschluß der Aktoren und/oder Sensoren versehen.

Die Anschlüsse 4 sind z.B. jeweils fünfpolig ausgebildet. Eine typische normgerechte Belegung ist wie folgt: "+, -, PE, zwei Schaltdrähte".

Nach Fig. 2 wird dagegen eine Ausbildung des Verteilers mit vier Anschlüssen 4a', 4b', 4c' und 4d' mit einer jeweils achtpoligen Ausbildung der Anschlußbuchsen gewählt, was rein schematisch im unteren Teil der Fig. 2 angedeutet ist. An die Anschlüsse könnten wiederum direkt Aktoren und/oder Sensoren angeschlossen werden.

Es ist aber dadurch, daß vier Schaltdrähte zur Verfügung stehen, auch denkbar eine Art Satellitenanordnung zu realisieren, bei welcher dem Verteiler 1 mit vier achtpoligen Anschlußbuchsen 4a', ... über Anschlußkabel 5 vier Satellitenverteiler 10a-d mit jeweils ebenfalls vier achtpoligen Anschlußbuchsen 4a', ... nachgeschaltet werden, wobei die Satellitenverteiler 10 keine eigene Elektronik aufweisen müssen. Auf diese Weise könnten beispielsweise jeweils 4DI-Geräte an die Anschlüsse der Satelliten angeschlossen werden.

## Patentansprüche

1. Verteiler für die Versorgung der Aktoren und/oder Sensoren mit Anschlüssen für die Aktoren und/oder Sensoren sowie einer Elektronik für die Versorgung der Aktoren und/oder Sensoren und die Weiterleitung der Aktoren-Sensoren-Signale, **dadurch gekennzeichnet, daß** die Anschlüsse (4a', ..) derart viel Pole aufweisen, daß eine Satellitenstruktur aus Verteilern (10a-d) gebildet werden kann, bei welcher an die Anschlüsse (4a',...) eines Verteilers (1) jeweils ein weiterer Satellitenverteiler (10), der seinerseits mehrere Anschlüsse aufweist, anschließbar ist.

2. Verteiler nach Anspruch 1, **dadurch gekennzeichnet, daß** der Verteiler (1) als passiver Verteiler ausgebildet ist.

3. Verteiler nach Anspruch 1 oder 2, **dadurch gekennzeichnet, daß** der Verteiler (1) mehrere, insbesondere vier, Anschlüsse (4a', ...) aufweist, welche jeweils mehrpolig, insbesondere achtpolig, ausgebildet sind und denen jeweils eine Mehrzahl, insbesondere vier, der Satellitenverteiler (10) nachschaltbar sind.

4. Verteiler nach Anspruch 1, 2 oder 3, **dadurch gekennzeichnet, daß** der Verteiler (1) vier Anschlüsse (4a', ...) aufweist, welche jeweils achtpolig ausgebildet sind und denen jeweils vier Satellitenverteiler (10) nachschaltbar sind.

5. Verteiler nach einem der Ansprüche 1 bis 4, **dadurch gekennzeichnet, daß** die Belegung der Anschlüsse (4a',...) des passiven Verteilers wie folgt ist: Plus, Minus, PE, mehrere - insbesondere vier - Schaltdrähte, vorzugsweise ein freier Anschluß.
